# EUROPEAN PATENT APPLICATION

(11) **EP 4 838 426 A1**
(43) Date of publication of application: **11.11.2026**
(21) Application number: 25175445.3
(22) Date of filing: 09.05.2025
(51) Int. Cl.: G06N 10/40, G06N 10/20, G06N 10/70

(54) **TIME-DEPENDENT, LOCAL, GATE-VOLTAGE-BASED CONTROL OF ENERGY SPLITTING AND 2D TOFFOLI GATE IMPLEMENTATION FOR SPIN QUBITS**

(71) Applicant: Hitachi, Ltd., Tokyo 100-8280 (JP)
(72) Inventor: OTXOA, Rubén M., Cambridge, CB3 0HE (GB); MARTINS, Frederico, Cambridge, CB3 0HE (GB); SMITH, Charles, Cambridge, CB3 0HE (GB); MERTIG, Normann, Cambridge, CB3 0HE (GB)
(74) Representative: Mewburn Ellis LLP

(57) **Abstract**

A method of preparing a set of quantum bit units for a quantum logic gate and a quantum device. Each quantum bit unit comprises a data qubit and a reference qubit, and the method comprises steps of: (i) applying a magnetic field to the set of quantum bit units to split a first set of degenerate energy levels of the data qubits into an intermediate set of energy levels, the intermediate set of energy levels including a second set of degenerate energy levels; and (ii) modulating coupling between the data qubit and reference qubit within one or more quantum bit units to cause further splitting in the second set of degenerate energy levels, thereby providing a set of non-degenerate energy levels for use in the quantum logic gate.

## Description

### Field of the Invention

The present invention relates to a method of preparing a set of quantum bit units for a quantum logic gate and particularly, although not exclusively, to the implementation of a 2D Toffoli gate for spin qubits by gate-voltage-based control of energy splitting.

### Background

Qubits are the fundamental computational building blocks of quantum computers. A qubit is a two-level system comprising an upper computational basis energy level and a lower computational basis energy level (often referred to as up and down states or 1 and 0 states). One of the defining characteristics of a quantum computer is the ability of the qubits to exist in a quantum superposition of the computational basis energy levels. A commercial quantum computer will require millions of qubits and the ability to perform both single-qubit and multi-qubit quantum logic gates. In order to achieve this, single-qubit addressability is required.

Many different qubit architectures are known in the art, for example: spin qubits, cold atom qubits, trapped ion qubits, photonic qubits, superconducting qubits, etc. The present disclosure will focus on spin qubits, but those skilled in the art will appreciate that the present disclosure is equally applicable to other qubit architectures.

The electron is a spin-1/2 particle (a fermion) and is thus well-suited to applications in quantum computing as the spin-up and spin-down states of the electron spin can act as the upper and lower computational basis energy levels of a qubit. Qubits formed using electron spin states are commonly referred to as spin qubits. One method of providing spin qubits is to form quantum dots in a semiconductor device and trap a single electron within each quantum dot. Spin qubits can be controlled with magnetic fields by using magnetic resonance techniques (e.g. electron paramagnetic resonance, EPR, also known as electron spin resonance, ESR) and can be controlled with electric fields by using electric dipole spin resonance (EDSR).

For example, a static magnetic field can be applied to a set of spin qubits to split the energies of the spin-up and spin-down states (by the Zeeman effect). A further oscillating magnetic field can be applied perpendicular to the static field at a frequency close to the energy splitting of a spin qubit to drive oscillations of the spin qubit around the Bloch sphere (e.g. to transition the spin qubit between the spin-up and spin-down states and superpositions thereof). These oscillations of the state of the spin qubit are also known as Rabi oscillations, and driving them to change the state of a qubit can be referred to as a single-qubit rotation.

A difficulty with this approach is that the applied magnetic fields are not localised, so they can affect multiple spin qubits at once, preventing single-qubit addressability among the set of spin qubits. To address this, and to provide single-qubit addressability, the resonant frequency of an individual spin qubit (that is, the energy splitting between the spin-up and spin-down states) may be shifted relative to other spin qubits.

Even setting aside the specific problem of addressability, the use of magnetic fields to manipulate spin qubits can be troublesome, as precise control over the magnetic fields is required. Tiny variations in the direction and magnitude of the magnetic fields can introduce undesired state configurations in the spin qubits. Various methods have been proposed to overcome these issues.

*Electron paramagnetic resonance*/*Electric dipole spin resonance (EPR*/*EDSR)* - these approaches involve inducing oscillating fields using coplanar waveguides/electrodes near spin qubit [1]. However, multiple spin qubits need to be sufficiently separated to be under different magnetic field amplitudes, consuming vital space and resulting in a trade-off between scalability and addressability.

*Micromagnets (MM)* - this approach involves installing a micromagnet nearby to spin qubits, resulting in a gradient magnetic field across the spin qubits [2-4]. A benefit of this approach is that the micromagnet not only leads to a large magnetic field gradient along a first direction, but it also introduces a small magnetic field component along a second direction perpendicular to the first. This results in location-dependent splitting of spin qubit energy levels, providing single-qubit addressability. However, the integration of micromagnets into a high density 2-dimensional array of spin qubits is technically very demanding, so once again there is a trade-off between scalability and addressability.

*Hyperfine interaction (HI)* - the hyperfine interaction describes the coupling between an electron and the nuclear spins of nearby atoms. By encoding a two-electron spin qubit in the singlet state (total spin angular momentum = 0) and triplet state (total spin angular momentum = 1) subspace of an electron in a quantum dot and an electron in a nearby donor atom, the hyperfine interaction enables certain types of entangling operation [5, 6]. However, this approach also introduces certain challenges, as the hyperfine interaction is a primary source of spin qubit decoherence, limiting the computational operational time in the absence of quantum error correction techniques.

*Spin-orbit Interaction (SOI)* - the spin-orbit interaction is a purely relativistic effect that couples an electron's spin and its linear momentum within a potential, and it can be exploited to modify the so-called g-factor of a spin qubit [7,8]. For example, in Si/SiO₂ heterostructures, large spin-orbit coupling has been observed due to the broken inversion symmetry at the Si/SiO₂ interface. This phenomenon leads to a variation of the g-factor from spin qubit to spin qubit and is a crucial resource to drive the evolution of two-electron spin qubits encoded into the singlet-triplet subspace [9-11]. This approach has the benefit of relying only on accurate control of the electrons that form the spin qubits, without the need to fabricate complex structures for embedding coplanar waveguides or micromagnets as discussed above. However, it is difficult to directly apply established optimal control methods (such as driving single-qubit rotations and pulse shaping) to this approach.

For an approach to spin qubit control to be a viable basis for the development of a utility-scale quantum computer, the approach should allow for both scalability and addressability, should have low cross-talk for the qubits, should allow error correction schemes to be applied to the qubits, and should allow the implementation of a universal set of quantum logic gates to which any operation on a quantum computer can be reduced. In Table 1, these conditions are applied to each of the approaches listed above.

**Table 1**

| | EPR/EDSR | MM | HI | SOI |
|---|---|---|---|---|
| Scalability and addressability | No | No | Possible | Possible |
| Cross-talk | High | High | Low | Low |
| Error correction schemes | No | No | No | No |
| Universal gate set implementation | No | Proposed | No | No |

One way to form a universal set of quantum logic gates is from the combination of the Hadamard gate and the Toffoli gate. The Hadamard gate is a single-qubit operation which transitions a qubit between a single computational basis state and an equal superposition of computational basis states. The Toffoli gate is a multi-qubit operation which transitions one qubit (the target qubit) between computational basis states conditional on the states of other qubits (control qubits).

The Toffoli gate can thus be seen as a generalisation of the NOT gate (or X gate), with the target qubit only transitioning between computational basis states if the control qubits are all in state |1〉. For one target qubit and one control qubit, the Toffoli gate reduces to a NOT gate. in the present disclosure, a Toffoli gate for one target qubit and two control qubits will be discussed, but it will be appreciated that the Toffoli gate can be generalised as an N-Toffoli gate for one target qubit and (N-1) control qubits.

In addition to allowing controlled transitions, the Toffoli gate also be used to create the quantum analogue of the classical NAND gate. As noted above, together with the Hadamard gate, the Toffoli gate can form a universal set of quantum logic gates. Moreover, a fault-tolerant encoded Toffoli gate can be constructed for any quantum stabilizer code [12].

For a set of three spin qubits (*s*₁, *s*₂, *s*₃), the operation of the Toffoli gate can be written as: $\left|{s}_{1}, {s}_{2}, {s}_{3}\right〉 \to \left|{s}_{1},{s}_{2},{s}_{3}⊕{s}_{1}∧{s}_{2}\right〉 ,$ where ⊕ is a XOR logical operation (mod 2 addition) and A is an AND operation. The Toffoli gate operates as follows when qubits 1 and 2 act as control qubits and qubit 3 acts as the target qubit: $\begin{matrix}{α}_{000} \left|000〉\right. + {α}_{001} \left|001〉\right. + {α}_{010} \left|010〉\right. + {α}_{100} \left|100〉\right. + {α}_{110} \left|110〉\right. + {α}_{101} \left|101〉+{α}_{011}\left|011〉\right.+{α}_{111}\left|111〉\right.\right. \\ ↓ Toff . \\ {α}_{000} \left|000〉\right. + {α}_{001} \left|001〉\right. + {α}_{010} \left|010〉\right. + {α}_{100} \left|100〉\right. + {α}_{111} \left|111〉\right. + {α}_{101} \left|101〉\right. + {α}_{011} \left|011〉\right. + {α}_{111} \left|110〉.\right.\end{matrix}$

The expression above shows that the Toffoli gate exchanges probability amplitudes between |111〉 and |110〉. Note that other qubits could have been selected as the target qubit ("t") and control qubits ("c"), such as |ctc〉 or |tcc〉, in which case the relevant energy levels would be |111〉 and |101〉 or |111〉 and |011〉 respectively. So, in order to provide complete flexibility and allow the Toffoli gate to be applied with any of the qubits acting as the target qubit, each of the transitions |111〉 ↔ |110〉, |111〉 ↔ |101〉, and |111〉 ↔ |011〉 should be well defined with a specific energy separation different to those of the other transitions. This will allow each of the transitions to be specifically addressable without disturbing the rest of the energy levels.

Of course, when scaling up from a Toffoli gate with 3 qubits to an N-Toffoli gate with a larger number of qubits, the number of transitions that need to be separately addressable will increase. Thus, when considering the Toffoli gate it is easy to see how scalability and addressability are intertwined with the ability to implement a universal set of quantum logic gates.

As discussed above, the EPR/EDSR, MM, HI, and SOI methods are possible approaches for generating the required energy splitting and resultant addressability. However, all these protocols come with drawbacks, specifically when it comes to hardware implementation and quantum chip design. This is especially true when the quantum architecture contains hundreds or even thousands of physical qubits.

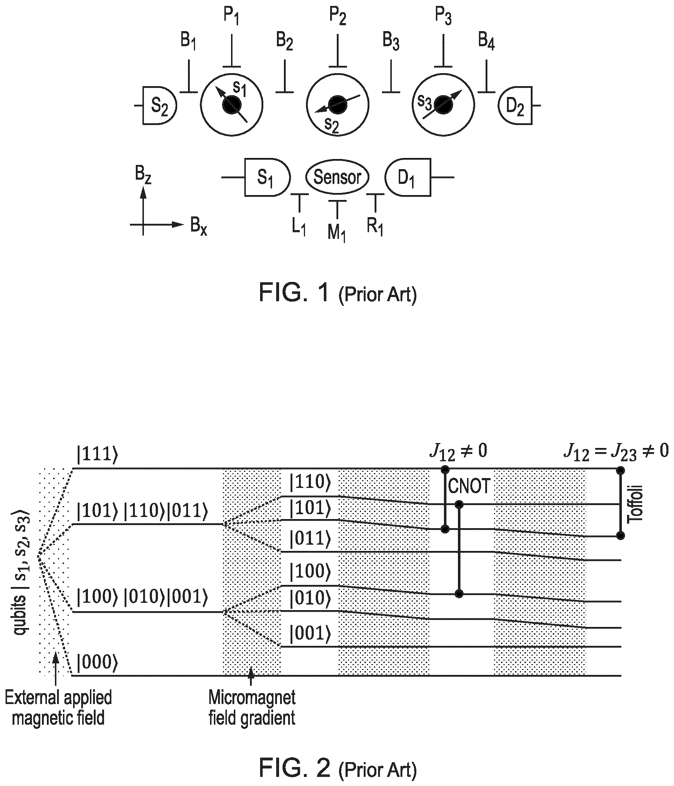

The Toffoli gate has been implemented in several quantum platforms [13-17]. Implementation of a 1D Toffoli gate in Silicon spin qubits has been proposed by Gullans and Petta, who suggested the use of a micromagnet to enable addressability [18]. A 1D Toffoli gate refers to a Toffoli gate implemented with a 1D array of qubits. Fig. 1 shows a schematic representation of a linear 1-dimensional array of spin qubits (*s*₁, *s*₂, *s*₃) formed in Silicon quantum dots, as considered by Gullans and Petta.

In Gullans and Petta's proposal, a set of electrodes (referred to as plunger gates Pᵢ) are used to control the occupancy of the quantum dots and to drive single-qubit rotations. Another set of electrodes (referred to as barrier gates Bᵢ) are used to control the coupling between the qubits (e.g. to control the strength of the exchange interaction between the qubits). A magnetic field gradient B*_{z}* along the z-direction enables individual addressability of each qubit, while a transverse field gradient B*ₓ* along the *x*-direction allows single-qubit rotations to be implemented. An additional quantum dot (referred to as a sensor dot) can be used to read out the spin state of each qubit via spin-to-charge conversion.

The Hamiltonian description for the system is given by $H = {\sum }_{i} {\vec{B}}_{i} ⋅ {\vec{s}}_{i} + {\sum }_{i = 1}^{N - 1} {J}_{i , i + 1} {\vec{s}}_{i} {\vec{s}}_{i + 1} ,$ where ℏ and *gµ_{B}* have been set to 1. The amplitude of the magnetic field applied to each individual spin qubit *sᵢ* is *Bᵢ* = *B*ₑₓₜ + *B*_{MM}, where Bₑₓₜ is an external globally applied magnetic field and *B*_{MM} is the magnetic field generated by a nearby micromagnet. *J*_{*i,i*+1} is the exchange interaction between spin qubit *sᵢ* and spin qubit *s*_{*i*+1}, which must be "turned on" in order to couple those qubits and allow CNOT and Toffoli quantum logic gates to be implemented.

Fig. 2 shows an energy level diagram for a 3-qubit system such as the one discussed by Gullans and Petta. |*s*₁*s*₂*s*₃〉 specifies the 3-qubit spin state, with 0 corresponding to spin-down and 1 corresponding to spin-up.

The far left side of the energy level diagram illustrates the application of a uniform external magnetic field, with no additional micromagnet field gradient and no exchange interactions (no coupling between qubits). Initially all states are degenerate, but application of the external field causes the |000〉 and |111〉 states to be split by the Zeeman energy, while the ${m}_{s} = - \frac{1}{2}$ manifold {|100〉, |010〉, |001〉} and the ${m}_{s} = + \frac{1}{2}$ manifold {|110〉, |101〉, |011〉} both have a threefold degeneracy.

The middle of the energy level diagram shows the effect of the z-component of the magnetic field *B*_{MM} from the micromagnet. This additional magnetic field gradient lifts the degeneracies of the ${m}_{s} = - \frac{1}{2}$ and ${m}_{s} = + \frac{1}{2}$ manifolds, allowing site-selective control of each qubit so that specific transitions can be addressed. However, it is important to note that these field gradients alone do not allow quantum logic gates to be carried out. The exchange interaction between the spin-qubits in question must first be turned on, after which a *π*-pulse resonant with the desired transition leads to the implementation of a gate.

The right side of the energy level diagram illustrates examples of transitions on which CNOT or Toffoli quantum logic gates can be carried out by single-qubit rotations. Turning on the exchange interaction between spin qubits s₁ and s₂ (J₁₂) allows CNOT quantum logic gates to be performed, by which the state of qubit s₂ is changed only if qubit s₁ is in the |1〉 state. Turning on the exchange interaction between spin qubits s₂ and s₃ (*J*₂₃) in addition to J₁₂ allows for a Toffoli gate to be performed, by which the state of qubit s₂ is changed only if qubits s₁ and s₃ are both in the |1〉 state [19].

This example demonstrates how a 1D Toffoli gate can be implemented by using micromagnets to engineer single-qubit addressability. However, as discussed above, there are notable downsides to the use of micromagnets, especially in terms of scalability and the technical demands of incorporating micromagnets into 2D arrays of Silicon spin qubits. Furthermore, it is not evident how a 1D Toffoli gate implementation could be accommodated into a quantum error correction code, so scalability to 2D Toffoli gate (implemented by 2D arrays of qubits) is crucial.

Therefore, it would be desirable to have a method of preparing a set of qubits for a quantum logic gate that engineers the energy level landscape of the qubits to lift degeneracies and provide addressability as required for said quantum logic gate, while limiting restrictions to scalability. More specifically, there is a need for a method of implementing a universal set of quantum logic gates in spin qubits (for example, by allowing Toffoli quantum logic gates to be carried out) that does not rely on the incorporation of micromagnets into the spin qubit architecture.

The present invention has been devised in light of the above considerations.

### Summary of the Invention

A utility scale quantum computer will need to have a greater number of physical qubits than logical qubits. In other words, some of the physical qubits may not be directly involved with carrying out quantum algorithms. For example, the physical qubits may include data qubits - those qubits whose states are manipulated by quantum logic gates to execute quantum algorithms - and reference qubits - those qubits which are used to monitor and obtain information about the states of the data qubits.

So far, the reference qubits have played a passive role in the implementation of quantum logic gates. The present inventors have recognised that the reference qubits are capable of playing a more active role. If there is no coupling between a data qubit and a reference qubit (e.g. the potential barrier between the qubits is sufficiently high), the qubits can be treated as independent units. If the data qubit and reference qubit are coupled (e.g. by lowering the potential barrier), then the qubits can interact with one another. The present invention exploits coupling between data and reference qubits to engineer the energy level landscape of the data qubits and prepare the data qubits for a quantum logic gate.

One way that data (d) and reference (r) qubits can be coupled is via the exchange interaction *J*_{d-r}. The exchange interaction is a purely quantum mechanical short-range Coulomb interaction between electrons with overlapping orbitals. Two types of exchange interaction can be present between such electrons: namely, isotropic (or so-called Heisenberg-type) and anisotropic (also named after Dzyaloshinskii and Moriya). The latter will be disregarded in the present disclosure.

The exchange interaction is particularly useful for coupling spin qubits formed by electrons trapped in quantum dots, since the strength of the coupling can be controlled electrostatically [19-21]. Therefore, when applying the present invention to spin qubits, control over electrical voltages applied to electrodes can be relied upon not just as a means to entangle spin qubits at will, but also to lift energy degeneracy and enable selective addressability of individual data qubits in a quantum chip. Disadvantages of the EPR/EDSR, MM, HI, and SOI approaches to engineering addressability (discussed above) can be avoided, and the impact on scalability can be reduced while also enabling a universal set of quantum logic gates by the execution of Toffoli quantum logic gates.

In a first aspect, embodiments of the present invention provide a method of preparing a set of quantum bit units for a quantum logic gate, each quantum bit unit comprising a data qubit and a reference qubit, the method comprising steps of:
(i) applying a magnetic field to the set of quantum bit units to split a first set of degenerate energy levels of the data qubits into an intermediate set of energy levels, the intermediate set of energy levels including a second set of degenerate energy levels; and
(ii) modulating coupling between the data qubit and reference qubit within one or more quantum bit units to cause further splitting in the second set of degenerate energy levels, thereby providing a set of non-degenerate energy levels for use in the quantum logic gate.

Advantageously, the method according to the first aspect provides site-specific, time-dependent control over the energy levels of the data qubits and enables scalable engineering of the energy landscape of the quantum device for implementing the quantum logic gate.

As will be discussed below, embodiments of the present invention can provide an implementation of a Toffoli gate on the quantum device while being compatible with error correction techniques and limiting restrictions to scalability. The present invention thus opens the door to less technically demanding and more flexible platforms for engineering a universal set of quantum logic gates on a quantum device.

As used herein, the term "qubit" may refer to the physical entity by which computational basis energy levels are being provided for use in the quantum logic gate (as opposed to referring to the computational basis energy levels themselves). For example, the term "qubit" may refer to any physical entity that can provide computational basis energy levels for use in a quantum logic gate, such as: an electron, a photon, a quantum dot, a cold atom or a cold molecule, a trapped ion, etc.

As used herein, the term "coupling" may refer to the exchange interaction between two (or more) qubits. The term "modulating coupling" may refer to modulating the strength of the exchange interaction between the two (or more) qubits, for example altering the value of the exchange coupling constant between the two (or more) qubits.

The set of quantum bit units may comprise at least two quantum bit units, optionally at least three quantum bit units. Each quantum bit unit may comprise exactly one data qubit and exactly one reference qubit.

The quantum logic gate may be a CNOT gate or a Toffoli gate. Nevertheless, it will be apparent to those skilled in the art that any suitable quantum logic gate that is known in the art may be implemented using the present invention.

The first set of degenerate energy levels may have a first energy. The second set of degenerate energy levels may have a second energy. The second energy may be different to the first energy.

The intermediate set of energy levels may include more than one set of degenerate energy levels, such as a plurality of sets of degenerate energy levels at respective energies. For example, the intermediate set of energy levels may include a second set of degenerate energy levels having a second energy and a third set of degenerate energy levels having a third energy. The third energy may be different to the second energy. The third energy may be different to the first energy. Step (ii) may comprise causing further splitting in one or more of, optionally all of, the plurality of sets of degenerate energy levels.

The intermediate set of energy levels may include a set of additional energy levels, each of the additional energy levels being non-degenerate with all other energy levels in the intermediate set. The set of non-degenerate energy levels may include one or more of the additional energy levels. In other words, one or more of the additional energy levels may be for use in the quantum logic gate.

Step (ii) may comprise causing further splitting such that all energy levels originating from the first set of degenerate energy levels are thereby non-degenerate.

Each qubit may be implemented by a quantum dot. Each quantum dot that forms a qubit may have a single electron confined therein. Such qubits may be referred to as spin qubits. The quantum dots may be formed in a semiconductor heterostructure. The semiconductor heterostructure may comprise a semiconductor material that hosts a two-dimensional electron gas. The semiconductor material may include Si, Ge, As, Ga, In, Sb or any combination of two or more of these materials, such as Si/SiGe, Ge/SiGe, or GaAs.

The semiconductor material may be covered (for example, covered on an upper surface thereof) by an insulating layer, for example an oxide. A metal layer may be positioned above the insulating layer (that is, on the opposite side of the insulating layer to the semiconductor material. The metal layer may provide one or more electrodes which, when supplied with a voltage, create a potential that confines charges (electrons or holes) within the two-dimensional electron gas.

For completeness, it is noted that electrodes may also be referred to as gates (e.g. barrier gates, plunger gates), although it will be appreciated that use of the term "gate" in the context of electrodes in a semiconductor heterostructure is distinct from use of the term "gate" in the context of quantum algorithms (e.g. quantum logic gates).

Each quantum bit unit may further comprise a charge sensor configured to read out the state of each spin qubit by spin-to-charge conversion. The charge sensor may be implemented by a quantum dot.

The method may further comprise a step, prior to step (i), of:
(a) verifying the initialisation of each of the data qubit and reference qubit within each quantum bit unit using the charge sensor within each quantum bit unit.

Step (a) may comprise verifying that a single spin (e.g. a single electron) is confined within the quantum dot of each data qubit. Step (a) may comprise verifying that a single spin (e.g. a single electron) is confined within the quantum dot of each reference qubit.

It will be appreciated by those skilled in the art that the present invention is not limited to spin qubits formed by electrons confined in quantum dots, and is equally applicable to other suitable qubit architectures that are known in the art, such as cold atom qubits, cold molecule qubits, trapped ion qubits, photonic qubits, superconducting qubits, etc.

Step (ii) may comprise symmetrically modulating coupling between the data qubit and reference qubit within one or more quantum bit units. Coupling between the data qubit and reference qubit of the or each quantum bit unit may be modulated symmetrically by altering a potential barrier between the data qubit and reference qubit within the or each quantum bit unit.

Step (ii) may comprise asymmetrically modulating coupling between the data qubit and reference qubit within one or more quantum bit units. Coupling between the data qubit and reference qubit of the or each quantum bit unit may be modulated asymmetrically by altering a confining potential of the reference qubit within the or each quantum bit unit. Alternatively, coupling between the data qubit and reference qubit of the or each quantum bit unit may be modulated asymmetrically by altering a confining potential of the data qubit within the or each quantum bit unit (although this may cause changes to the energy levels of the data qubit that may affect coupling between the data qubit and another data qubit from a different quantum bit unit).

Step (ii) may comprise symmetrically modulating coupling between the data qubit and reference qubit of some quantum bit units and asymmetrically modulating coupling between the data qubit and reference qubit of other quantum bit units. Additionally or alternatively, step (ii) may comprise modulating coupling between the data qubit and reference qubit of one or more quantum bit units both symmetrically and asymmetrically. In other words, the one or more quantum bit units for which the coupling is modulated may comprise a primary set of quantum bit units, for which the coupling is modulated symmetrically, and a secondary set of quantum bit units, for which the coupling is modulated asymmetrically. The primary and secondary sets may each comprise one or more quantum bit units. Some (or all) of the quantum bit units may be in both the primary set and the secondary set - in other words, the primary set and the secondary set may intersect.

Step (ii) may comprise applying respective electric fields to the or each quantum bit unit to modulate coupling between the data qubit and reference qubit within the or each quantum bit unit. The respective electric fields may have respective different magnitudes and/or respective different gradients.

In some examples, respective electric fields may already be applied to the or each quantum bit unit prior to step (ii), in which case "applying respective electric fields" may be interpreted as altering the respective pre-existing electric fields. For example, an electric field may define the height of the potential barrier between the data qubit and the reference qubit within a quantum bit unit, and the height of potential barrier may be altered to modulate coupling by applying an additional electric field or by altering the pre-existing electric field. Additionally or alternatively, an electric field may define the confining potential of the reference qubit within a quantum bit unit, and the confining potential may be altered to modulate coupling by applying an additional electric field or by altering the pre-existing electric field.

The respective electric fields may be applied to the or each quantum bit unit by supplying voltages to respective electrodes arranged with the or each quantum bit unit. The voltages may have respectively different amplitudes.

Step (ii) may comprise modulating coupling between the data qubit and reference qubit within two or more quantum bit units such that the data qubit and reference qubit within the two or more quantum bit units have respective different couplings.

Step (ii) may comprise modulating coupling between the data qubit and reference qubit within all but one of the quantum bit units such that the data qubit and reference qubit within each quantum bit unit have respective different couplings.

Step (ii) may comprise modulating coupling between the data qubit and reference qubit within all quantum bit units such that the data qubit and reference qubit within each quantum bit unit have respective different couplings.

The method may further comprise a step of:
(iii) modulating coupling between data qubits of different quantum bit units to shift energy levels within the set of non-degenerate energy levels to provide separately addressable transitions within the set of non-degenerate energy levels for use in the quantum logic gate.

As used herein, the term "shift" may refer to changing the energy of an energy level, for example changing the separation between an energy level and one or more other energy levels.

As used herein, the term "transitions" may refer to changes to the state of a qubit, for example excitations and/or relaxations of the qubit between energy levels of the qubit such as an upper computational energy level and a lower computational energy level.

As used herein, the term "separately addressable" may refer to the transitions having respective different energies. The energy of a transition may be calculated as the energy separation between two energy levels that define the transition. To be separately addressable, the difference between the respective energies of the transitions may be large enough that one transition can be driven without driving other transitions (or without driving other transitions to an appreciable degree, for example without causing a measurable population change between the energy levels of other transitions).

In some examples, the data qubits of different quantum bit units may not be coupled prior to step (iii). For example, the exchange interaction between data qubits of different quantum bit units may have zero magnitude. In this case, step (iii) may comprise turning on coupling between data qubits of different quantum bit units. For example, step (iii) may comprise altering the magnitude of the exchange interaction between data qubits of different quantum bit units to be non-zero (e.g. altering the value of the exchange coupling constant between data qubits of different quantum bit units to be non-zero).

Step (iii) may comprise sequentially modulating coupling between each pairwise combination of data qubits.

Data qubits of different quantum bit units may be coupled via a multi-electron coupler. Nevertheless, it will be apparent to those skilled in the art that any suitable method that is known *per se* in the art may be used to couple data qubits of different quantum bit units.

The multi-electron coupler may be arranged between the quantum bit units (or between the data qubits thereof). The quantum bit units (or the data qubits thereof) may be equally spaced around the multi-electron coupler.

Coupling between data qubits of different quantum bit units may be modulated by bringing energy levels of the multi-electron coupler into resonance with energy levels of said data qubits.

Energy levels of the multi-electron coupler may be brought into resonance with energy levels of data qubits by altering the confining potential of the multi-electron coupler. The confining potential may be altered by applying one or more electric fields to the multi-electron coupler. The one or more electric fields may be applied by supplying a voltage to one or more electrodes arranged with the multi-electron coupler.

Additionally or alternatively, energy levels of the multi-electron coupler may be brought into resonance with energy levels of data qubits by altering the respective potential barriers between each of said data qubits and the multi-electron coupler. The potential barriers may be altered by applying one or more electric fields between the multi-electron coupler and the respective data qubits. The one or more electric fields may be applied by supplying a voltage to one or more electrodes arranged with the multi-electron coupler and the respective data qubits.

In some examples, respective electric fields may already be applied to the multi-electron coupler and/or between data qubits and the multi-electron coupler prior to step (iii), in which case "applying one or more electric fields" may be interpreted as altering the pre-existing electric fields. For example, an electric field may define the confining potential of the multi-electron coupler, and the confining potential may be altered to modulate coupling between data qubits of a different quantum bit units by applying an additional electric field or by altering the pre-existing electric field. In another example, an electric field may define the height of the potential barrier between a data qubit and the multi-electron coupler, and the height of the potential barrier may be altered to modulate coupling between the data qubit and a data qubit of a different quantum bit unit by applying an additional electric field or by altering the pre-existing electric field.

The multi-electron coupler may be as described in PCT patent application no. PCT/JP2024/009339, the entirety of which is incorporated herein by reference.

The multi-electron coupler may comprise a quantum dot in which an even number of electrons are confined, the quantum dot of the multi-electron coupler being separated from each of the data qubits by respective potential barriers. In this case, the term "energy levels of the multi-electron coupler" may refer to energy levels of the quantum dot of the multi-electron coupler, and the term "the confining potential of the multi-electron coupler" may refer to the confining potential of the quantum dot of the multi-electron coupler.

The quantum dot of the multi-electron coupler may be formed in a semiconductor heterostructure. The semiconductor heterostructure may be as defined above.

If the multi-electron coupler comprises a quantum dot, step (a) may further comprise verifying that an even number of electrons are confined within the quantum dot of the multi-electron coupler.

The method may further comprise a step of:
(iv) driving one or more single-qubit rotations to transition at least one data qubit between energy levels to implement the quantum logic gate.

Step (iv) may comprise driving exactly one single-qubit rotation and/or may comprise transitioning exactly one data qubit between energy levels.

Step (iv) may comprise transitioning a target qubit among the data qubits between energy levels, the transition being conditional on the states of control qubits, the control qubits comprising data qubits other than the target qubit. The control qubits may comprise all data qubits other than the target qubit.

In some examples, there may be exactly one control qubit, in which case the quantum logic gate may be a CNOT gate.

Each of the data qubits may have an upper computational basis energy level and a lower computational basis energy level. The upper computational basis energy level may be at a higher energy than the lower computational basis energy level. The upper and lower computational basis energy levels may be referred to as "spin-up" and "spin-down" respectively, or as "1" and "0" respectively. Step (iv) may comprise transitioning the target qubit between its upper computational basis energy level and lower computational basis energy level.

Step (iv) may comprise transitioning the target qubit between its upper and lower computational basis energy levels only if each of the control qubits is in a preselected one of their respective upper computational basis energy level and lower computational basis energy level.

Step (iv) may comprise transitioning the target qubit between its upper and lower computational basis energy levels only if the control qubits are all in their respective upper computational basis energy levels, thereby implementing a Toffoli gate as the quantum logic gate.

The control qubits may comprise exactly two data qubits, or two or more data qubits..

In step (iv), the one or more single-qubit rotations may be driven by applying one or more oscillating magnetic fields to the at least one data qubit. Additionally or alternatively, the one or more single-qubit rotations may be driven by applying one or more oscillating electric fields to the at least one data qubit. For example, if the data qubits are spin qubits, standard electron paramagnetic resonance and/or electric dipole spin resonance techniques may be used to drive the one or more single-qubit rotations. Nevertheless, it will be apparent to those skilled in the art that any suitable method that is known *per se* in the art may be used to drive the one or more single-qubit rotations.

Optionally, the method according to the first aspect of the invention may be computer-implemented.

In a second aspect, embodiments of the present invention provide a computer-readable medium comprising instructions which, when executed by a computer, cause the computer to carry out the method according to the first aspect.

In a third aspect, embodiments of the present invention provide a quantum device comprising:
a set of quantum bit units, each quantum bit unit comprising a data qubit and a reference qubit; and
a controller configured to perform the method according to the first aspect.

The set of quantum bit units may comprise at least two quantum bit units, optionally at least three quantum bit units. Each quantum bit unit may comprise exactly one data qubit and exactly one reference qubit.

Each qubit may be implemented by a quantum dot. Each quantum dot that forms a qubit may have a single electron confined therein. Such qubits may be referred to as spin qubits. It will be appreciated by those skilled in the art that the present invention is not limited to spin qubits formed by electrons confined in quantum dots, and is equally applicable to other suitable qubit architectures that are known in the art, such as cold atom qubits, cold molecule qubits, trapped ion qubits, photonic qubits, superconducting qubits, etc.

The quantum dots may be formed in a semiconductor heterostructure. The semiconductor heterostructure may comprise a semiconductor material that hosts a two-dimensional electron gas. The semiconductor material may include Si, Ge, As, Ga, In, Sb or any combination of two or more of these materials, such as Si/SiGe, Ge/SiGe, or GaAs.

The semiconductor material may be covered (for example, covered on an upper surface thereof) by an insulating layer, for example an oxide. A metal layer may be positioned above the insulating layer (that is, on the opposite side of the insulating layer to the semiconductor material. The metal layer may provide one or more electrodes which, when supplied with a voltage, create a potential that confines charges (electrons or holes) within the two-dimensional electron gas. The electrodes may also be referred to as gates.

The quantum device may further comprise a first set of electrodes arranged to create confining potentials for each of the qubits when the first set of electrodes are supplied with voltages. The confining potentials may be created by the first set of electrodes generating electric fields when the first set of electrodes are supplied with voltages. If the qubits are implemented by quantum dots, then "confining potentials for each of the qubits" may refer to confining potentials for the quantum dots of each of the qubits.

The quantum device may further comprise a second set of electrodes, each electrode of the second set being arranged with (or at) a respective quantum bit unit to modulate coupling between the data qubit and reference qubit of the respective quantum bit unit by applying an electric field to the quantum bit unit when the electrode is supplied with a voltage. Some electrodes may be in both the first set of electrodes and the second set of electrodes - in other words, the first and the second set of electrodes may intersect.

The second set of electrodes may comprise barrier electrodes. Each barrier electrode may be arranged to symmetrically modulate coupling between the data qubit and reference qubit of a respective quantum bit unit by altering a potential barrier between the data qubit and the reference qubit with the electric field generated by the barrier electrode. Each barrier electrode may be arranged between the data qubit and reference qubit of its respective quantum bit unit.

The second set of electrodes may additionally or alternatively comprise plunger electrodes. Each plunger electrode may be arranged to asymmetrically modulate coupling between the data qubit and reference qubit of a respective quantum bit unit by altering a confining potential of the reference qubit with the electric field generated by the plunger electrode. Each plunger electrode may be arranged at or adjacent to the reference qubit of its respective quantum bit unit.

The quantum device may further comprise a multi-electron coupler. The multi-electron coupler may be as described above for the first aspect of the present invention.

The multi-electron coupler may comprise a quantum dot in which an even number of electrons are confined, the quantum dot of the multi-electron coupler being separated from each of the data qubits by respective potential barriers. The quantum dot of the multi-electron coupler may be formed in a semiconductor heterostructure. The semiconductor heterostructure may be as defined above.

The quantum device may further comprise a third set of electrodes arranged to create a confining potential for the quantum dot of the multi-electron coupler when the third set of electrodes are supplied with voltages. The confining potential may be created by the third set of electrodes generating electric fields when the third set of electrodes are supplied with voltages. The third set of electrodes may be arranged at and/or adjacent to and/or around the multi-electron coupler.

Some electrodes may be in both the first set of electrodes and the third set of electrodes and/or in both the second set of electrodes and the third set of electrodes - in other words, the third set of electrodes may intersect with the first set of electrodes and/or the second set of electrodes.

The quantum device may further comprise a fourth set of electrodes arranged with the multi-electron coupler and the data qubits, the fourth set of electrodes being arranged to alter the respective potential barriers between the data qubits and the multi-electron coupler when the electrodes are supplied with voltages, thereby modulating coupling between data qubits of different quantum bit units. The potential barriers may be altered by the fourth set of electrodes applying one or more electric fields between the multi-electron coupler and the data qubits when the fourth set of electrodes are supplied with voltages.

Some electrodes may be in both the first set of electrodes and the fourth set of electrodes and/or in both the second set of electrodes and the fourth set of electrodes and/or in both the third set of electrodes and the fourth set of electrodes - in other words, the fourth set of electrodes may intersect with the first set of electrodes and/or the second set of electrodes and/or the third set of electrodes.

The multi-electron coupler may be arranged between the quantum bit units (or between the data qubits thereof). For example, the quantum bit units may be arranged around the perimeter of a circle. The multi-electron coupler may be arranged at the centre of the circle. That is, the quantum bit units may be arranged around the perimeter of the multi-electron coupler.

The quantum bit units (or the data qubits thereof) may be equally spaced around the multi-electron coupler. For example, the quantum bit units may be arranged around the perimeter of a circle (or around the perimeter of the multi-electron coupler), separated by equal angles. More specifically, if there are three quantum bit units, the quantum bit units may be separated by equal angles of 60 degrees.

Within each quantum bit unit, the data qubit and the reference qubit may be arranged along an alignment axis, with the data qubit closer to the multi-electron coupler than the reference qubit is. If the quantum bit units are arranged around the perimeter of a circle (or around the perimeter of the multi-electron coupler, the alignment axes of different quantum bit units may intersect at the centre of the circle.

Each quantum bit unit may further comprise a charge sensor configured to read out the state of each spin qubit by spin-to-charge conversion. The charge sensor may be implemented by a quantum dot.

Within each quantum bit unit, the charge sensor may be offset from the alignment axis. The charge sensor may be separated from the data qubit and reference qubit by a confinement electrode (or at least a portion of a confinement electrode). The confinement electrode (or the at least a portion of a confinement electrode) may extend parallel to the alignment axis.

The confinement electrode (or the at least a portion of a confinement electrode) may be part of one or more of the first, second, third, or fourth sets of electrodes. For example, the confinement electrode (or the at least a portion of a confinement electrode) may be part of the first set of electrodes and the fourth set of electrodes.

Further embodiments of the present invention provide: a computer program comprising code which, when run on a computer, causes the computer to perform the method of the first aspect; a computer readable medium storing a computer program comprising code which, when run on a computer, causes the computer to perform the method of the first aspect; and a computer system programmed to perform the method of the first aspect.

The invention includes the combination of the aspects and preferred features described except where such a combination is clearly impermissible or expressly avoided.

### Summary of the Figures

Embodiments and experiments illustrating the principles of the invention will now be discussed with reference to the accompanying figures in which:
**Figure 1** shows a schematic representation of a prior art linear 1-dimensional array of spin qubits;
**Figure 2** shows an energy level diagram for the prior art linear 1-dimensional array of spin qubits shown in Fig. 1;
**Figures 3(a) and 3(b)** show schematic representations of a semiconductor heterostructure according to embodiments of the present invention;
**Figure 3(c)** shows a simplified graphical representation of a confining potential of the semiconductor heterostructure shown in Figures 3(a) and 3(b);
**Figures 4(a) and 4(b)** show schematic representations of a quantum bit unit of a quantum device according to embodiments of the present invention;
**Figure 4(c)** shows a simplified graphical representation of confining potentials of the quantum bit unit shown in Figures 4(a) and 4(b);
**Figure 5** shows an energy level diagram for data qubits of a quantum device according to embodiments of the present invention;
**Figure 6** shows a schematic representation of a quantum device according to embodiments of the present invention;
**Figure 7** shows another schematic representation of a quantum device according to embodiments of the present invention;
**Figure 8** shows a sequence for coupling each pairwise combination of data qubits in a quantum device according to embodiments of the present invention;
**Figure 9** shows an energy level diagram for the implementation of a 2D Toffoli gate with a quantum device according to embodiments of the present invention.

### Detailed Description of the Invention

Aspects and embodiments of the present invention will now be discussed with reference to the accompanying figures. Further aspects and embodiments will be apparent to those skilled in the art. All documents mentioned in this text are incorporated herein by reference.

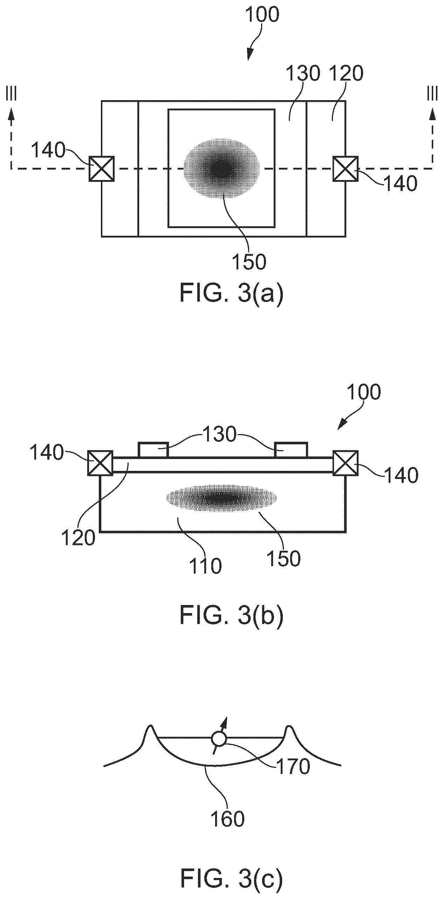

Figs. 3(a) and 3(b) show schematic representations of a semiconductor heterostructure 100 according to embodiments of the present invention. Fig. 3(a) shows a top-down view of the semiconductor heterostructure 100 and Fig. 3(b) shows a section taken along the line III-III of Fig. 3(a).

Semiconductor heterostructure 100 comprises a semiconductor material 110 (see Fig. 3(b)) that hosts a two-dimensional electron gas. Semiconductor material 110 may comprise for example Si, Si/SiGe, Ge/SiGe, or GaAs. Semiconductor material 110 is covered (on an upper surface thereof) by an insulating layer 120, such as an oxide. Positioned above insulating layer 120 (that is, on the opposite side of insulating layer 120 to the semiconductor material 110) is at least one metal layer 130 that provides one or more electrodes. The electrodes may also be referred to as gates (e.g. barrier gates, plunger gates), although it will be appreciated that use of the term "gate" in the context of electrodes in a semiconductor heterostructure is distinct from use of the term "gate" in the context of quantum algorithms (e.g. quantum logic gates).

Voltages applied to the electrodes create a potential 160 (see Fig. 3(c)) that confines one or more charges (electrons or holes) within the two-dimensional electron gas, forming a quantum dot. Ohmics 140 (also known as ohmic contacts) are used to the load one or more charges into the confining potential 160 as charge cloud 150.

Fig. 3(c) shows a simplified graphical representation of a confining potential 160. A single electron 170 is confined within the confining potential 160. The spin of the electron 170 (represented by an arrow in Fig. 3(c)) can be a spin-up or spin-down. The spin-up and spin down states are associated with distinct energy levels of a qubit, which may be respectively referred to as upper and lower computational basis energy levels. The term "qubit" is used herein to refer to the physical entity that provides computational basis energy levels for use in a quantum logic gate, namely the quantum dot and the single electron confined therein (as opposed to referring to e.g. the upper and lower computational basis energy levels themselves). Qubits formed by single spins confined within quantum dots are referred to herein as spin qubits.

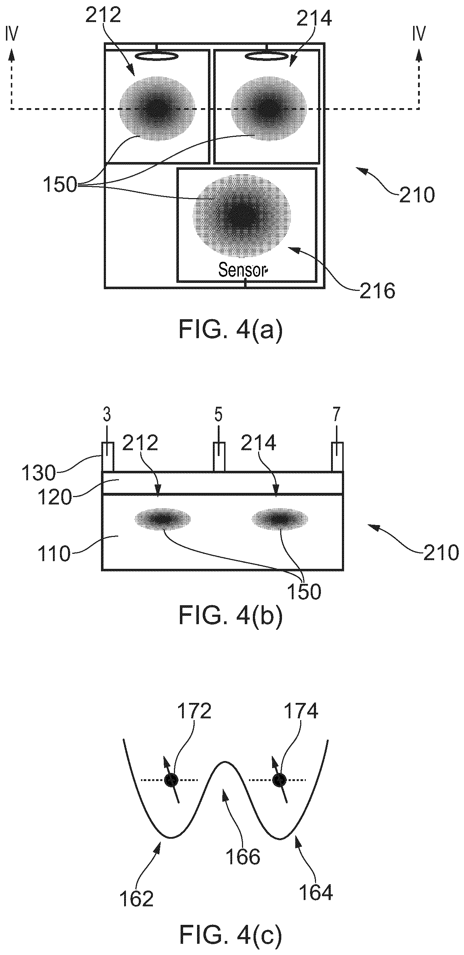

Fig. 4(a) and 4(b) show schematic representations of a quantum bit unit 210 of a quantum device 200 according to embodiments of the present invention. Fig. 4(a) shows a top-down view of the quantum bit unit 210 and Fig. 4(b) shows a section taken along the line IV-IV of Fig. 4(a).

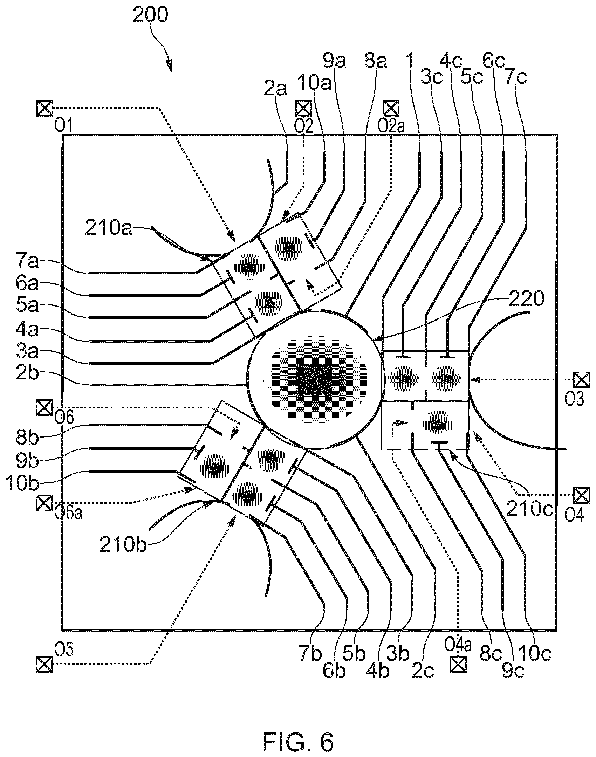

Quantum device 200 (see Figs. 6-7) comprises a semiconductor heterostructure with which the quantum bit unit 210 is implemented, the semiconductor heterostructure having the same layers 110, 120, 130 as the semiconductor heterostructure shown in Figs. 3(a)-(b). Quantum bit unit 210 includes two spin qubits - a data qubit 212 and a reference qubit 214. The data qubit 212 and the reference qubit 214 are both formed by single electrons (represented as charge clouds 150 in Figs. 4(a) and 4(b)) confined within quantum dots as described above. To enhance clarity, the charge accumulation regions of each qubit 212, 214 are surrounded by black boxes in Fig. 4(a).

Electrodes 3, 5, 7 (see Fig. 4(b)) form part of a first set of electrodes of the quantum device 200 (see Figs. 6-7). The first set of electrodes are arranged to create electrostatic confining potentials 162, 164 (see Fig. 4(c)) for the respective qubits 212, 214 by the first set of electrodes generating electric fields when the first set of electrodes are supplied with voltages. Supplying appropriate voltages to the first set of electrodes (e.g. electrodes 3, 5, 7) thus allows the confining potentials 162, 164 of the qubits 212, 214 to be shaped as desired.

Quantum bit unit 212 may also include a charge sensor 216. The charge sensor 216 is another quantum dot that can be used to read out the states of the data qubit 212 and the reference qubit 214 by spin-to-charge conversion. As will be described later, the charge sensor 216 may be used to verify that a single electron is confined within the quantum dot of each qubit 212, 214. To enhance clarity, the charge accumulation region of charge sensor 216 is surrounded by a black box in Fig. 4(a).

Fig. 4(c) shows a simplified graphical representation of the confining potential 162 of the data qubit 212 and the confining potential 164 of the reference qubit 214. A single electron 172 is confined within confining potential 162 to form the data qubit 212 and a single electron 174 is confined within confining potential 164 to form the reference qubit 214. A potential barrier 166 separates the electrons 172, 174.

The spin of electron 172 (represented by an arrow in Fig. 4(c)) has a spin-up energy level which acts as the upper computational basis energy level of data qubit 212 and a spin-down energy level which acts as the lower computational basis energy level of data qubit 212. The spin of electron 174 (represented by an arrow in Fig. 4(c)) has a spin-up energy level which acts as the upper computational basis energy level of reference qubit 214 and a spin-down energy level which acts as the lower computational basis energy level of reference qubit 214.

The quantum device 200 comprises a set of quantum bit units 210. Embodiments of the present invention provide a method of preparing the set of quantum bit units 210 for a quantum logic gate. The set of quantum bit units 210 may include for example at least two quantum bit units 210 or at least three quantum bit units 210, but the present invention is scalable to arbitrary numbers of quantum bit units 210 as will be demonstrated herein.

The total Hamiltonian *H*ₜₒₜ(*t*) for a set of quantum bit units 210 consists of the Zeeman energy (*H*_{Zee}) coming from all the data qubits 212 and all the reference qubits 214, as well as the time-variable coupling (*H*_{exc}(*t*)) between the respective data qubit 212 and reference qubit 214 within each quantum bit unit 210 (said coupling arising from the exchange interaction between the data qubit 212 and the reference qubit 214 within each quantum bit unit 210). Accounting for all the quantum bit units 210 in the set of quantum bit units 210 (in this analysis, an arbitrary number), *H*ₜₒₜ(*t*) is $\begin{matrix}{H}_{tot} \left(t\right) = {\sum }_{i} {H}_{Zee}^{i} + {\sum }_{i} {H}_{exc}^{i} \left(t\right) \\ = {\vec{B}}_{ext} ⋅ {\sum }_{i} {\vec{s}}_{d}^{i} + {\vec{B}}_{ext} ⋅ {\sum }_{i} {\vec{s}}_{r}^{i} + {\sum }_{i} {J}_{d - r}^{i} \left(t\right) \left({\vec{s}}_{d}^{i}⋅{\vec{s}}_{r}^{i}\right) ,\end{matrix}$ where *B*ₑₓₜ refers to an external global magnetic field (a magnetic field applied to all the quantum bit units 210, i.e. to all the data qubits 212 and all the reference qubits 214). ${s}_{d}^{i}$ and ${s}_{r}^{i}$ respectively stand for vectors representing basis states (energy levels) of the data qubit 212 and reference qubit 214 in each quantum bit unit 210. The super-index 'i' runs over all the quantum bit units 210. Finally, ${J}_{d - r}^{i} \left(t\right)$ stands for the exchange coupling constant between the data qubit 212 and the reference qubit 214 within the same quantum bit unit 210, and is normalized to avoid double counting.

The exchange coupling constant ${J}_{d - r}^{i} \left(t\right)$ between the data qubit 212 and reference qubit 214 of the *i*-th quantum bit unit 210 is given by ${J}_{d - r}^{i} \left(t\right) = \frac{2 {T}_{c}^{2}}{\sqrt{{ϵ}^{2} + 4 {T}_{c}^{2}} - ϵ} ,$ where *T*_{c} represents the effect of the potential barrier 166 between the data qubit 212 and the reference qubit 214 on the exchange coupling constant, and ε represents the effect of the detuning between confining potential 162 of the data qubit 212 and confining potential 164 of the reference qubit 214 on the exchange coupling constant. Control over the confining potentials 162, 164 and the potential barrier 166 thus enables control over the exchange coupling constant ${J}_{d - r}^{i} \left(t\right)$.

The expression of the total Hamiltonian *H*ₜₒₜ(*t*) can be partially differentiated with respect to the i^{th} data qubit to obtain $\frac{\partial }{\partial {\vec{s}}_{d}^{i}} {H}_{tot} \left(t\right) = {\vec{B}}_{ext} + {J}_{d - r}^{i} \left(t\right) {\vec{s}}_{r}^{i} .$

Through dimensional analysis, the terms on the right side of the above equation have units of a magnetic field, implying that each reference qubit 214 creates a field-like effect on the data qubit 212 within the same quantum bit unit 210. In other words, the above equation suggests that the influence of each reference qubit 214 on the data qubit 212 within the same quantum bit unit 210 can be interpreted as a local exchange-based magnetic field.

Just as an external applied magnetic field can cause energy levels of the qubits 212, 214 to shift due to the Zeeman effect, this local exchange-based magnetic field can cause the energy levels of the data qubit 212 to shift dependent on the strength of coupling between the data qubit 212 and the reference qubit 214 within the same quantum bit unit 210. In other words, the energy levels of the data qubit 212 adjust in response to the presence and configuration of the reference qubit 214 within the same quantum bit unit 210.

A method of preparing a set of quantum bit units 210 for a quantum logic gate according to embodiments of the present invention comprises modulating coupling between the data qubit 212 and the reference qubit 214 within one or more quantum bit units 210, thereby allowing energy levels of the data qubits 212 to be dynamically controlled at an individual level and in a time-varying manner. The energy levels can be shifted and/or energy level degeneracies can be broken at will. Embodiments of the present invention provide flexible, site-specific control over the quantum states of the data qubits 212, allowing a set of quantum bit units 210 to be prepared for a quantum logic gate by providing a set of non-degenerate energy levels for use in the quantum logic gate.

This approach to preparing data qubits 212 for a quantum logic gate provides addressability while limiting restrictions to scalability and avoiding technically demanding interventions to the architecture of the quantum device 200. The present invention addresses difficulties of the EPR/EDSR, MM, HI, and SOI approaches discussed above and, as will be discussed below, allows a universal set of quantum logic gates to be implemented with the data qubits 212 while also being compatible with error correction techniques. The present invention represents an advancement in tailoring interactions within a quantum device, enhancing control over qubit coherence, and facilitating the design of desired quantum states.

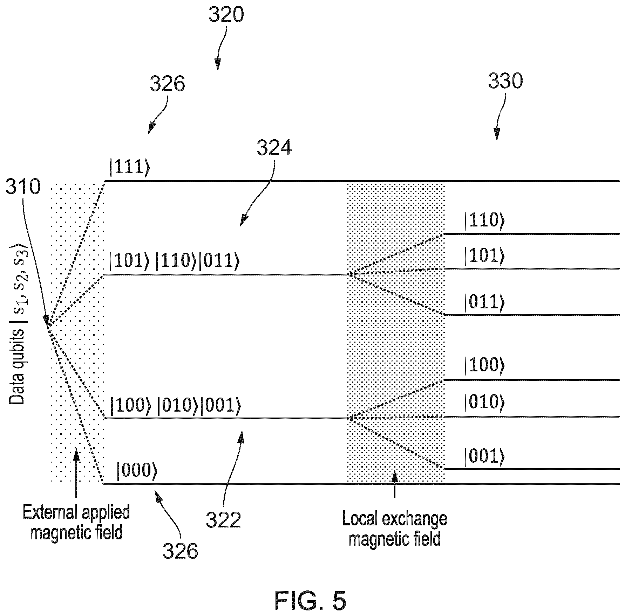

A method of preparing a set of quantum bit units 210 for a quantum logic gate according to embodiments of the present invention will now be described with reference to Fig. 5. Fig. 5 shows an energy level diagram for the data qubits 212 of a quantum device 200 according to the present invention. In this example, the quantum device 200 comprises a set of three quantum bit units 210, but it will be appreciated that the present invention may be implemented with a different number of quantum bit units 210 as desired.

In the energy level diagram of Fig. 5, |*s*₁*s*₂*s*₃〉 specifies the 3-qubit spin state of the data qubits 212, with 0 corresponding to the lower computational basis state (or spin-down) and 1 corresponding to the upper computational basis state (or spin-up). In the absence of an external magnetic field and with no coupling between qubits 212 (that is, no coupling between data qubits 212 of different quantum bit units 210 and no coupling between the data qubit 212 and reference qubit 214 within each quantum bit unit 210), all the 3-qubit spin states are degenerate. The data qubits 212 thus have a first set of degenerate energy levels 310, the first set of degenerate energy levels 310 having a first energy (at the convergence point of the dotted lines in Fig. 5) and comprising all 3-qubit states.

The method comprises a first step (i) of applying a magnetic field to the set of quantum bit units 210 to split the first set of degenerate energy levels 310 into an intermediate set of energy levels 320. This step is illustrated on the left side of Fig. 5. Application of the magnetic field causes the |000〉 and |111〉 states to be split by the Zeeman energy, while the ${m}_{s} = - \frac{1}{2}$ manifold {|100〉, |010〉, |001〉} and the ${m}_{s} = + \frac{1}{2}$ manifold {|110〉, |101〉, |011〉} both have a threefold degeneracy.

In this example, the intermediate set of energy levels 320 comprises a second set of degenerate energy levels 322, comprising the ${m}_{s} = - \frac{1}{2}$ manifold, and a third set of degenerate energy levels 324, comprising the ${m}_{s} = + \frac{1}{2}$ manifold. As can be seen from Fig. 5, the second set of degenerate energy levels 322 has a second energy which is different to the first energy, and the third set of degenerate energy levels 324 has a third energy which is different to both the first energy and the second energy. The intermediate set of energy levels 320 further comprises a set of additional energy levels 326 (comprising the |000〉 and |111〉 states), each of which is non-degenerate with all other energy levels in the intermediate set 320.

It will be appreciated that the number of energy levels, and the number of sets of degenerate energy levels in the intermediate set, depends on the number of data qubits 212 present in the quantum device 200. For example, with two data qubits 212 the intermediate set of energy levels will comprise a second set of degenerate energy levels but not a third set of degenerate energy levels. With more than three data qubits 212, the intermediate set of energy levels will comprise further sets of degenerate energy levels in addition to a second set of degenerate energy levels and a third set of degenerate energy levels.

The method further comprises a second step (ii) of modulating coupling between the data qubit 212 and reference qubit 214 within one or more quantum bit units 210 to cause further splitting in the second set of degenerate energy levels 324, thereby providing a set of non-degenerate energy levels 330 for use in the quantum logic gate. This step is illustrated on the right side of Fig. 5.

In this example, further splitting is caused in both the second 322 and third 324 sets of degenerate energy levels. Furthermore, further splitting is caused such that all energy levels originating from the first set of degenerate energy levels 310 (that is, all the 3-qubit energy levels) are thereby non-degenerate. Nonetheless, it will be appreciated by those skilled in the art that for some quantum logic gates it may not be necessary to break the degeneracy of all sets of degenerate energy levels, nor to engineer all multi-qubit states to be non-degenerate. The present invention allows the exact splitting to be tailored to the desired quantum logic gate by site-specific control over which quantum bit units 210 have their coupling modulated, thereby providing complete flexibility over the numbers of degenerate and non-degenerate energy levels.

There are symmetric and asymmetric routes to changing the exchange interaction between two qubits [22-25]. Embodiments of the present invention include both symmetric and asymmetric modulation of coupling between the data qubit 212 and the reference qubit 214 within the same quantum bit unit 210.

Referring again to Fig. 4(c), symmetric modulation can be achieved by altering the potential barrier 166 between the data qubit 212 and the reference qubit 214, thereby changing *T*_{c} in the equation for ${J}_{d - r}^{i} \left(t\right)$. Asymmetric modulation (also known as tilt or detuning control) can be achieved by altering the confining potential 164 of the reference qubit 124 (or by altering the confining potential 162 of the data qubit 212), thereby changing ε in the equation for ${J}_{d - r}^{i} \left(t\right)$. Of course, it is possible to modulate coupling between a data qubit 212 and reference qubit 214 both symmetrically and asymmetrically by altering the potential barrier 166 and a confining potential 162, 164 simultaneously.

Referring again to Fig. 4(b), electrode 5 acts as a so-called barrier electrode. When electrode 5 is supplied with a voltage, it generates an electric field which alters the potential barrier 166 to modulate coupling between the data qubit 212 and the reference qubit 214 in a symmetric manner.

As will be discussed later, the quantum device 200 according to embodiments of the present invention further comprises electrodes 4,6 (not shown in Fig. 4(b)) which act as so-called plunger electrodes for the data qubit 212 and reference qubit 214 respectively. When electrodes 4,6 are supplied with voltages, they generate electric fields which respectively alter the confining potential 162 of the data qubit 212 and the confining potential 164 of the reference qubit 214 to modulate coupling between said qubits in an asymmetric manner.

Since symmetric modulation preserves the symmetry of the charge distribution between the data qubit 212 and the reference qubit 214, it is expected to be more favourable for achieving high quantum logic gate fidelities [26,27]. Asymmetric modulation hybridizes the wave functions of the data qubit 212 and reference qubit 214, which can cause some unwanted mixed states (such as a single quantum dot containing two electrons). Nonetheless, both symmetric modulation and asymmetric modulation provide advantageous site-specific control of the energy landscape of the data qubits 212.

The method of preparing a set of quantum bit units 210 for a quantum logic gate according to embodiments of the present invention may further comprise a third step (ii) of modulating coupling between data qubits 212 of different quantum bit units 210 to shift energy levels within the set of non-degenerate energy levels 330 to provide separately addressable transitions within the set of non-degenerate energy levels 330 for use in the quantum logic gate.

As previously discussed herein, coupling between the qubits to which a quantum logic gate is to be applied can be "turned on" to allow suitable transitions to be driven for the implementation of the quantum logic gate. In the quantum device 200 according to embodiments of the present invention, the quantum logic gate is to be applied to the data qubits 212. Step (iii) allows coupling between the data qubits 212 of different quantum bit units 210 to be "turned on" so that the quantum logic gate can be implemented.

Those skilled in the art will appreciate that any suitable method and/or device architecture that is known *per se* in the art may be used to couple data qubits 212 of different quantum bit units 210. Nevertheless, embodiments of the present invention provide a method and device architecture which advantageously enables control of the coupling between data qubits 212 of different quantum bit units 210 with low cross-talk.

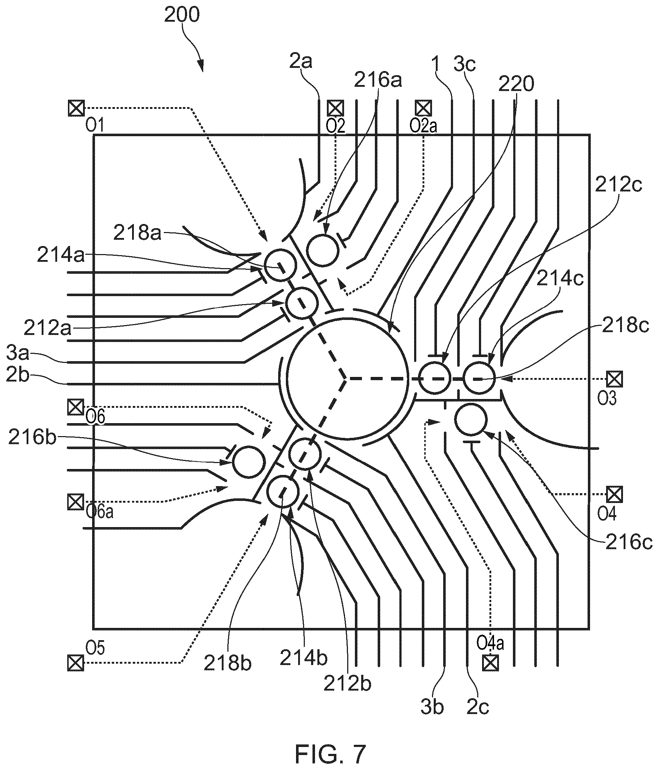

Figs. 6 and 7 show schematic representations of a quantum device 200 according to embodiments of the present invention. The quantum device 200 comprises a set of three quantum bit units 210a, 210b, 210c, but it will be appreciated that the quantum device 200 may comprise any number of quantum bit units 210 as desired. The quantum bit units 210a, 210b, 210c are arranged in a 2-dimensional array. As discussed below, embodiments of the present invention enable the implementation of a 2D Toffoli gate (a Toffoli gate implemented with a 2D array of qubits).

The data qubits 212a, 212b, 212c of the quantum bit units 210a, 210b, 210c may be coupled via a multi-electron coupler (MEC) 220. The multi-electron coupler 220 is arranged between the quantum bit units 210a, 210b, 210c, with the quantum bit units 210a, 210b, 210c equally spaced around the multi-electron coupler 220.

For clarity, in Fig. 6 the charge accumulation regions of the quantum bit units 210a, 210b, 210c are surrounded by black boxes and the charge accumulation region of the multi-electron coupler 220 is surrounded by a black circle. In Fig. 7, the qubits and the multi-electron coupler 220 are shown as grey circles.

As shown in Fig. 7, within each quantum bit unit 210a, 210b, 210c, the data qubit 212a, 212b, 212c and the reference qubit 214a, 214b, 214c are arranged along a respective alignment axis 218a, 218b, 218c, with the data qubit 212a, 212b, 212c closer to the multi-electron coupler 220 than the reference qubit is 214a, 214b, 214c. The alignment axes 218a, 218b, 218c intersect at the centre of the multi-electron coupler 220.

Within each quantum bit unit 210a, 210b, 210c, the charge sensor 216a, 216b, 216c is offset from the respective alignment axis 218a, 218b, 218c. The charge sensor 216a, 216b, 216c is separated from the respective data qubit 212a, 212b, 212c and reference qubit 214a, 214b, 214c by a portion of a confinement electrode 2a, 2b, 2c (discussed in more detail below), the portion of confinement electrode 2a, 2b, 2c extending parallel to the respective alignment axis 218a, 218b, 218c.

The multi-electron coupler 220 comprises a quantum dot in which an even number of electrons are confined, the quantum dot of the multi-electron coupler being separated from each of the data qubits 212a, 212b, 212c by respective potential barriers. The diameter of the multi-electron coupler 220 may be from about 100 nm to about 500 nm, although the present invention is not limited to a multi-electron coupler 220 this size. A diameter from about 100 nm to about 500 nm helps to reduce crosstalk between quantum bit units 210a, 210b, 210c as the quantum bit units 210a, 210b, 210c are spaced more than 200 nm apart.

Coupling between data qubits 212a, 212b, 212c of different quantum bit units 210a, 210b, 210c may be modulated by bringing energy levels of the multi-electron coupler 220 into resonance with energy levels of the desired combination of data qubits 212a, 212b, 212c.

For example, the confining potential of the multi-electron coupler 220 may be altered by applying one or more electric fields to the multi-electron coupler 220. Additionally or alternatively, the respective potential barriers between each of the desired data qubits 212a, 212b, 212c and the multi-electron coupler 220 may be altered by applying one or more electric fields between the multi-electron coupler 220 and the respective data qubits 212a, 212b, 212c.

The Hamiltonian ${H}_{tot}^{MEC} \left(t\right)$, including distant exchange interaction between data qubits 212 through the multi-electron coupler 220, contains all the following interactions:
1. Global magnetic field acting over the data qubits 212 and refence qubits 214.
2. Local exchange-based interactions between the data qubits 212 and the reference qubits 214 within the same quantum bit unit 210.
3. Local exchange-based interaction, through the multi-electron coupler 220, between data qubits 212 within different quantum bit units 210. ${H}_{tot}^{MEC} \left(t\right) = {\vec{B}}_{ext} ⋅ \left({\sum }_{i} {\vec{s}}_{d}^{i}+{\sum }_{i} {\vec{s}}_{r}^{i}\right) + {\sum }_{i} {J}_{d - r}^{i} \left(t\right) \left({\vec{s}}_{d}^{i}⋅{\vec{s}}_{r}^{i}\right) + {\sum }_{i , j} {J}_{d - d} \left(t\right) \left({\vec{s}}_{d}^{i}⋅{\vec{s}}_{d}^{j}\right)$

*J*_{d-d}(*t*) stands for the exchange coupling constant between data qubits 212 that belong to different quantum bit units 210 but are able to interact through the multi-electron coupler 220. *J*_{d-d}(*t*) is normalized to avoid double counting when calculating the interaction energy. It is assumed that the value of *J*_{d-d}(*t*) does not depend upon the label of the data qubit 212. However, the value of *J*_{d-d}(*t*) may depend on time in a similar fashion to ${J}_{d - r}^{i} \left(t\right)$, allowing similar time-dependent control.

The semiconductor heterostructure 100 of the quantum device 200 enables this functionality by providing a plurality of electrodes in the metal layer 130:
- Electrode 1: a plunger electrode configured to generate a confining potential of the multi-electron coupler 220.
- Electrodes 1, 2a, 2b, 2c: confinement electrodes configured to generate confining potentials of the multi-electron coupler 220 and the respective quantum bit units 210a, 210b, 210c.
- Electrodes 3a, 3b, 3c: barrier electrodes configured to generate potential barriers between the multi-electron coupler 220 and the respective data qubits 212a, 212b, 212c.
- Electrodes 4a, 4b, 4c: plunger electrodes configured to generate confining potentials of the respective data qubits 212a, 212b, 212c.
- Electrodes 5a, 5b, 5c: barrier electrodes configured to generate potential barriers between the respective data qubits 212a, 212b, 212c and reference qubits 214a, 214b, 214c within each quantum bit unit 210a, 210b, 210c.
- Electrodes 6a, 6b, 6c: plunger electrodes configured to generate confining potentials of the respective reference qubits 214a, 214b, 214c.
- Electrodes 7a, 7b, 7c: barrier electrodes configured to generate potential barriers between the reference qubits 214a, 214b, 214c and respective Ohmics O1, O5, O3.
- Electrodes 8a, 8b, 8c: barrier electrodes configured to generate potential barriers between the charge sensors 216a, 216b, 216c and respective Ohmics O2a, O6, O4a.
- Electrodes 9a, 9b, 9c: plunger electrodes configured to generate confining potentials of the respective charge sensors 216a, 216b, 216c.
- Electrodes 10a, 10b, 10c: barrier electrodes configured to generate potential barriers between the charge sensors 216a, 216b, 216c and respective Ohmics O2, O6a, O4.

The quantum device 200 thus comprises a first set of electrodes arranged to create confining potentials for each of the qubits 212, 214 when the first set of electrodes are supplied with voltages. The quantum device 200 further comprises a second set of electrodes, each electrode of the second set being arranged with (or at) a respective quantum bit unit 210 to modulate coupling between the data qubit 212 and reference qubit 214 of the respective quantum bit unit 210 by applying an electric field to the quantum bit unit 210 when the electrode is supplied with a voltage.

The quantum device 200 further comprises a third set of electrodes arranged to create a confining potential for the quantum dot of the multi-electron coupler 220 when the third set of electrodes are supplied with voltages. The quantum device 200 further comprises a fourth set of electrodes arranged with the multi-electron coupler 200 and the data qubits 212, the fourth set of electrodes being arranged to alter the respective potential barriers between the data qubits 212 and the multi-electron coupler 220 when the electrodes are supplied with voltages, thereby modulating coupling between data qubits 212 of different quantum bit units 210.

From the descriptions above, it is clear that some electrodes may belong to multiple sets. For example, since a potential barrier is a part of the confinement potential of each of the quantum dots it separates, electrodes 3a, 3b, 3c and 5a, 5b, 5c may belong to both the first set of electrodes and the second set of electrodes. That is, different sets of electrodes may intersect.

The quantum dots of all quantum bit units 210 and the multi-electron coupler 220 can be loaded by supplying appropriate voltages to electrodes 3 to 10, after which:
- Ohmics O2, O2a, O4, O4a, O6, O6a supply the charges to the quantum dots of the charge sensors 216a, 216b, 216c.
- Ohmics O1, O3, O5 supply charges to the quantum dots of the reference qubits 214a, 214b, 214c, the data qubits 212a, 212b, 212c, and the MEC 220.

In Figs. 6 and 7, dotted arrows indicate paths of charge supply from Ohmics to charge confinement regions. The voltages supplied to electrodes 1, 2a, 2b, 2c, and 3a, 3b, 3c can be controlled to prevent any leakage of electrons from the multi-electron coupler 220.

Suitably, a method of preparing a set of quantum bit units 210 for a quantum logic gate according to embodiments of the present invention may comprise a step, prior to step (i), of (a) verifying the initialisation of each of the data qubit 212 and reference qubit 214 within each quantum bit unit 210 using the charge sensor 216 within each quantum bit unit 210.

In step (a), spin-to-charge conversion can be used to verify that a single electron is confined within the quantum dot of each data qubit 212 and each reference qubit 214. Step (a) may further comprise verifying that an even number of electrons are confined within the quantum dot of the multi-electron coupler 220.

So, initialisation of the quantum device 200 may involve:
- Applying voltages to all electrodes.
- Initializing the charge sensors 216 of all quantum bit units 210 to detect charges. This involves turning on barrier electrodes 8,10 and pulling in charges from Ohmics O2, O4, O6 with plunger electrodes 9.
- Using the Ohmics O1, O3, O5 to supply charges to the multi-electron coupler 220 as well as the data qubits 212 and reference qubits 214 of all quantum bit units 210. This involves the use of plunger electrodes 1, 4 and 6 (and potentially barrier electrodes 3, 5, 7) to implement electron shuttling [18].
- Using the charge sensors 216 to ensure that the multi-electron coupler 220 has an even number of electrons, and all data qubits 212 and reference qubits 214 have a single electron.

With the methods and device architectures described above, the present invention allows distant data qubits 212 to be coupled across the multi-electron coupler 220 to prepare the data qubits 212 for a quantum logic gate. Since coupling between data qubits 212 and reference qubits 214 within the same quantum bit unit 210 and also between data qubits 212 of different quantum bit units 210 can both be controlled by supplying voltages to electrodes, the present invention provides scalable and flexible control that helps to implement quantum logic gates across the set of quantum bit units 210. This present invention thus supports more versatile quantum operations on a quantum chip.

Furthermore, a key benefit of coupling the data qubits 212 of different quantum bit units 210 via the multi-electron coupler 220 is that it results in low cross-talk. That is, changing electrode voltages for one quantum bit unit 210 has almost no effect on the other quantum bit units 210.

Additionally, the device architecture described above is compatible with quantum error correction schemes, specifically aligning with the surface code architecture, as noted in PCT patent application no. PCT/JP2024/009338, the entirety of which is incorporated herein by reference. This compatibility with error correction is crucial for implementing fault-tolerant quantum computing and offers a promising path towards practical and resilient quantum devices.

The implementation of a quantum logic gate using the methods and devices of the present invention will now be described.

A method of preparing a set of quantum bit units 210 for a quantum logic gate according to embodiments of the present invention may comprise a fourth step (iv) of transitioning a target qubit among the data qubits 212 between energy levels, the transition being conditional on the states of control qubits, the control qubits comprising data qubits 212 other than the target qubit.

As previously described herein, any data qubit 212 may be chosen as the target qubit, and the time-dependent and site-selective control provided by the present invention allows the energy landscape of the data qubits 212 to be engineered as required for the desired quantum logic gate and desired choice of target qubit. The control provided by the present invention is scalable and, as will now be demonstrated, allows the implementation of a universal set of quantum logic gates by engineering a Toffoli gate.

To implement a Toffoli gate as the quantum logic gate, step (iv) comprises transitioning the target qubit between its upper and lower computational basis energy levels only if the control qubits are all in their respective upper computational basis energy levels.

As already noted herein, the present invention is applicable to any number of data qubits 212. The control qubits may comprise exactly two data qubits 212, or two or more data qubits 212.

It will be apparent to those skilled in the art that any suitable method that is known *per se* in the art may be used to drive single-qubit rotations for transitioning the target qubit.

An example control sequence for implementing a Toffoli gate with the quantum device 200 according to embodiments of the present invention will now be described. It will be apparent that the control sequence incorporates steps from a method of preparing the set of quantum bit units 210 of the quantum device 200 for a quantum logic gate (here, a Toffoli gate).

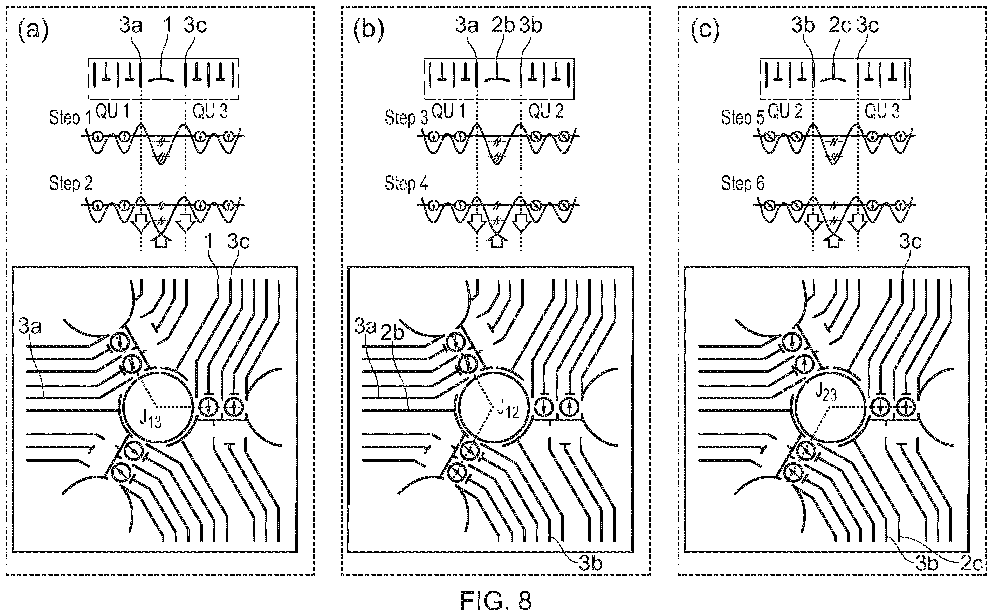

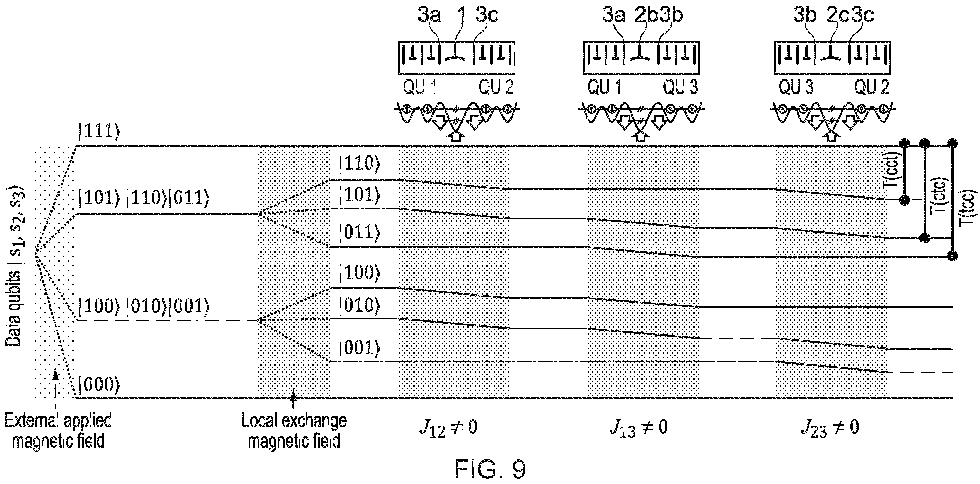

To set the conditions for implementing the Toffoli gate, the following sequence may be carried out:
- *Initialization:*
   o For each quantum bit unit 210, use plunger electrodes 4 and 6 to put both electrons in the quantum dot of the reference qubit 214, then relax to the singlet state.
   o Ramp the voltage on plunger electrodes 4 and 6 to have one electron in the quantum dot of the data qubit 212 and one electron in the quantum dot of the reference qubit 214.
- *Energy landscape tuning:*
   ∘ Apply a global magnetic field to lift the degeneracy of the first set of degenerate energy levels 310 (see Fig. 5).
   ∘ Supply voltages to electrodes 1 and 2 to isolate the multi-electron coupler 200 from the quantum bit units 210.
   ∘ Supply voltages of different amplitude to barrier electrode 5 and/or plunger electrode 6 of each qubit unit 210 to modulate the exchange interaction in a symmetric and/or asymmetric fashion, leading to a further energy splitting and securing the distinction among all the multi-qubit states (see Fig. 5).
- *Toffoli gate implementation:*
   ∘ Use electrodes 1, 3a and 3c to turn on the exchange interaction J₁₃ between data qubit 212a and data qubit 212c (see panel (a) of Fig. 8, discussed below).
   ∘ Use electrodes 2b, 3a and 3b to turn on the exchange interaction J₁₂ between data qubit 212a and data qubit 212b (see panel (b) of Fig. 8, discussed below).
   ∘ Use electrodes 2c, 3b and 3c to turn on the exchange interaction J₂₃ between data qubit 212b and data qubit 212c (see panel (c) of Fig. 8, discussed below).
   ∘ These steps lead to a variation of the energy landscape each individual data qubit 212 experiences and allows for a distinction among all possible multi-qubit states (see Fig. 9, discussed below).
   ∘ For a predetermined choice of control qubits and target qubit, one can tune into the frequency corresponding to the desired energy transition to implement the Toffoli gate, by which the target qubit is transitioned between its computational basis energy states only if all the control qubits are in the 1 state (see Fig. 9, discussed below). The transition can be implemented by single-qubit rotations performed following standard methods [4].
- *Readout:*
   o To read the state of the target qubit, use the corresponding plunger electrodes to probe the Pauli-spin blockade [28,29].

Fig. 8 shows a sequence for coupling each pairwise combination of data qubits 212 in quantum device 200 according to embodiments of the present invention. In Fig. 8, **QU 1** is used as a label for quantum bit unit 210a, **QU 2** is used as a label for quantum bit unit 210b, and **QU 3** is used as a label for quantum bit unit 210c.

In panel (a), the *J*_{d-d}(*t*) exchange interaction is activated for quantum bit units 210a and 210c. In panel (b), the *J*_{d-d}(*t*) exchange interaction is activated for quantum bit units 210a and 210b. In panel (c), the *J*_{d-d}(*t*) exchange interaction is activated for quantum bit units 210b and 210c. Arrows indicate the spins of the reference 214 and data 212 qubits in the three quantum bit units 210. The dashed lines in the lower section of each panel indicate exchange between the relevant data qubits 210.

The upper section of each panel shows the confining potential of each combination of data qubits 212 with the multi-electron coupler 220, along with a visualisation of the relevant electrodes involved. Prior to the procedure, spins are well isolated in the quantum bit units 210, with the charges in the multi-electron coupler 220 resting at lower energy levels.

In Figure 8 panel (a), changing the voltage on plunger electrode 1 lifts states in the multi-electron coupler 220 to energies resonant with states in quantum bit units 210a and 210c. In panel (b), changing the voltage on plunger electrode 2b lifts states in the multi-electron coupler 220 to energies resonant with states in quantum bit units 210a and 210b. In panel (c), changing the voltage on plunger electrode 2c lifts states in the multi-electron coupler 220 to energies resonant with states in quantum bit units 210b and 210c. Moreover, in each panel, voltages on the relevant barrier electrodes 3 are changed to lower the potential barrier between the respective data qubits 212 and the multi-electron coupler 220.

Fig. 9 shows an energy level diagram for the implementation of a 2D Toffoli gate with a quantum device 200 according to embodiments of the present invention. In the energy level diagram of Fig. 9, |*s*₁*s*₂*s*₃〉 specifies the 3-qubit spin state of the data qubits 212, with 0 corresponding to the lower computational basis state (or spin-down) and 1 corresponding to the upper computational basis state (or spin-up). In Fig. 9, **QU 1** is used as a label for quantum bit unit 210a, **QU 2** is used as a label for quantum bit unit 210c, and **QU 3** is used as a label for quantum bit unit 210b.

Fig. 9 is an extension of the energy level diagram shown in Fig. 5. After the external magnetic field and local exchange-based couplings are turned on, *J*_{d-d}(*t*) exchange couplings J₁₂, J₁₃, and J₂₃ are pulsed on as described above with reference to Fig. 8. Three separately addressable transitions may then be driven (labelled as T(cct), T(ctc), and T(tcc) in Fig. 9), with the choice of transition depending on which data qubit 212 should act as the target qubit.

As shown by Fig. 9, it is important to note that the control and target qubits are not predefined in the structure of the multi-electron coupler 220 or the arrangement of electrodes. As a result, any data qubit 212 can act as the target qubit, highlighting the flexibility of the present invention. The same principles could be extended to a multi-electron coupler 220 surrounded by N quantum bit units 210, allowing the implementation of N-Toffoli gates, in which (N-1) data qubits 212 act as the control qubits.

The primary use of the present invention is quantum compilation approaches occurring in quantum computation. The present invention provides a scalable, spin-qubit based architecture reference qubits 214 to realize tuneable energy splitting of data qubits 212 by means of exchange coupling. Moreover, exchange interactions between data qubits 212 can be mediated by a multi-electron coupler 220 to realize a qubit architecture with low crosstalk. The present invention has particular usefulness in engineering Toffoli gates to realize a universal gate set for error corrected quantum computing.

The systems and methods of the above embodiments may be implemented in a computer system (in particular in computer hardware or in computer software) in addition to the structural components and user interactions described.

The term "computer system" includes the hardware, software and data storage devices for embodying a system or carrying out a method according to the above described embodiments. For example, a computer system may comprise a central processing unit (CPU), input means, output means and data storage. The computer system may have a monitor to provide a visual output display. The data storage may comprise RAM, disk drives or other computer readable media. The computer system may include a plurality of computing devices connected by a network and able to communicate with each other over that network.

The methods of the above embodiments may be provided as computer programs or as computer program products or computer readable media carrying a computer program which is arranged, when run on a computer, to perform the method(s) described above.

The term "computer readable media" includes, without limitation, any non-transitory medium or media which can be read and accessed directly by a computer or computer system. The media can include, but are not limited to, magnetic storage media such as floppy discs, hard disc storage media and magnetic tape; optical storage media such as optical discs or CD-ROMs; electrical storage media such as memory, including RAM, ROM and flash memory; and hybrids and combinations of the above such as magnetic/optical storage media.

While the disclosure has been described in conjunction with the exemplary embodiments described above, many equivalent modifications and variations will be apparent to those skilled in the art when given this disclosure. Accordingly, the exemplary embodiments of the disclosure set forth above are considered to be illustrative and not limiting. Various changes to the described embodiments may be made without departing from the spirit and scope of the disclosure.

In particular, although the methods of the above embodiments have been described as being implemented on the systems of the embodiments described, the methods and systems of the present disclosure need not be implemented in conjunction with each other, but can be implemented on alternative systems or using alternative methods respectively.

The features disclosed in the foregoing description, or in the following claims, or in the accompanying drawings, expressed in their specific forms or in terms of a means for performing the disclosed function, or a method or process for obtaining the disclosed results, as appropriate, may, separately, or in any combination of such features, be utilised for realising the invention in diverse forms thereof.

While the invention has been described in conjunction with the exemplary embodiments described above, many equivalent modifications and variations will be apparent to those skilled in the art when given this disclosure. Accordingly, the exemplary embodiments of the invention set forth above are considered to be illustrative and not limiting. Various changes to the described embodiments may be made without departing from the spirit and scope of the invention.

For the avoidance of any doubt, any theoretical explanations provided herein are provided for the purposes of improving the understanding of a reader. The inventors do not wish to be bound by any of these theoretical explanations.

Any section headings used herein are for organizational purposes only and are not to be construed as limiting the subject matter described.

Throughout this specification, including the claims which follow, unless the context requires otherwise, the word "comprise" and "include", and variations such as "comprises", "comprising", and "including" will be understood to imply the inclusion of a stated integer or step or group of integers or steps but not the exclusion of any other integer or step or group of integers or steps.

It must be noted that, as used in the specification and the appended claims, the singular forms "a," "an," and "the" include plural referents unless the context clearly dictates otherwise. Ranges may be expressed herein as from "about" one particular value, and/or to "about" another particular value. When such a range is expressed, another embodiment includes from the one particular value and/or to the other particular value. Similarly, when values are expressed as approximations, by the use of the antecedent "about," it will be understood that the particular value forms another embodiment. The term "about" in relation to a numerical value is optional and means for example +/- 10%.

### References

A number of publications are cited above. Full citations for these references are provided below. The entirety of each of these references is incorporated herein by reference.
[1] Driven coherent oscillations of a single electron spin in a quantum dot. Nature 442, 766-771 (2006).
[2] A fault-tolerant addressable spin qubit in a natural silicon quantum dot. Science advances 2, e1600694 (2016).
[3] Coherent single electron spin control in a slanting Zeeman field. Physical review letters 96, 047202 (2006).
[4] Electrically driven single-electron spin resonance in a slanting Zeeman field. Nature Physics 4, 776-779 (2008).
[5] Coherent coupling between a quantum dot and a donor in silicon. Nature Communications 8, 1029 (2017).
[6] Coherent singlet-triplet oscillations in a silicon-based double quantum dot. Nature 481, 344-347 (2012).
[7] Electrical control of a long-lived spin qubit in a Si/SiGe quantum dot. Nature Nanotechnology 9, 666-670 (2014).
[8] A two-qubit logic gate in silicon. Nature 526, 410-414 (2015).
[9] Spin-orbit mediated control of spin qubits. Physical Review Letters 97, 240501 (2006).
[10] Singlet-triplet splitting in double quantum dots due to spin-orbit and hyperfine interactions. Physical Review B 85, 075416 (2012).
[11] Fidelity benchmarks for two-qubit gates in silicon. Nature 569, 532-536 (2019).
[12] Quantum error correction and fault tolerant quantum computing (CRC Press, 2008).
[13] Experimental quantum error correction. Physical Review Letters 81, 2152 (1998).
[14] Experimental realization of Shor's quantum factoring algorithm using nuclear magnetic resonance. Nature 414, 883-887 (2001).
[15] Realization of the quantum Toffoli gate with trapped ions. Physical Review Letters 102, 040501 (2009).
[16] Implementation of a Toffoli gate with superconducting circuits. Nature 481, 170-172 (2012).
[17] Toffoli, and CNOT gates via Rydberg blockade of neutral atoms. Physical Review Applied 9, 051001 (2018).
[18] Protocol for a resonantly driven three-qubit Toffoli gate with silicon spin qubits. Physical Review B 100, 085419 (2019).
[19] Quantum computation with quantum dots. Physical Review A 57, 120 (1998).
[20] Two-qubit gate of combined single-spin rotation and interdot spin exchange in a double quantum dot. Physical review letters 107, 146801 (2011).
[21] Spins in few-electron quantum dots. Reviews of modern physics 79, 1217 (2007).
[22] Semiconductor spin qubits. Reviews of Modern Physics 95, April-June (2023).
[23] Coherent Manipulation of Coupled Electron Spins in Semiconductor Quantum Dots. Science 309, 5744 pp 2180-2184 (2005).
[24] Noise Suppression Using Symmetric Exchange Gates in Spin Qubits. Physical Review Letters 116, 116801 (2016).
[25] Reduced Sensitivity to Charge Noise in Semiconductor Spin Qubits via Symmetric Operation. Physical Review Letters 116, 110402 (2016).
[26] Singlet-triplet splitting in double quantum dots due to spin-orbit and hyperfine interactions. Physical Review B 85, 075416 (2012).
[27] Noise suppression using symmetric exchange gates in spin qubits. Physical Review Letters 116, 116801 (2016).
[28] Fast High-Fidelity Single-Shot Readout of Spins in Silicon Using a Single-Electron Box" Physical Review X 13, 011023 (2023).
[29] Probing quantum devices with radio-frequency reflectometry, Appl. Phys. Rev. 10, 021305 (2023).
[30] High-fidelity quantum gates in Si/SiGe double quantum dots, Phys. Rev. B 97, 085421 (2018).

## Claims

1. A method of preparing a set of quantum bit units for a quantum logic gate, each quantum bit unit comprising a data qubit and a reference qubit, the method comprising steps of:
(i) applying a magnetic field to the set of quantum bit units to split a first set of degenerate energy levels of the data qubits into an intermediate set of energy levels, the intermediate set of energy levels including a second set of degenerate energy levels; and
(ii) modulating coupling between the data qubit and reference qubit within one or more quantum bit units to cause further splitting in the second set of degenerate energy levels, thereby providing a set of non-degenerate energy levels for use in the quantum logic gate.

2. The method according to claim 1, wherein step (ii) comprises symmetrically modulating coupling between the data qubit and reference qubit within one or more quantum bit units.

3. The method according to claim 2, wherein coupling between the data qubit and reference qubit of the or each quantum bit unit is modulated symmetrically by altering a potential barrier between the data qubit and reference qubit within the or each quantum bit unit.

4. The method according to any preceding claim, wherein step (ii) comprises asymmetrically modulating coupling between the data qubit and reference qubit within one or more quantum bit units.

5. The method according to claim 4, wherein coupling between the data qubit and reference qubit of the or each quantum bit unit is modulated asymmetrically by altering a confining potential of the reference qubit within the or each quantum bit unit.

6. The method according to any preceding claim, wherein step (ii) comprises applying respective electric fields to the or each quantum bit unit to modulate coupling between the data qubit and reference qubit within the or each quantum bit unit.

7. The method according to claim 6, wherein the respective electric fields are applied to the or each quantum bit unit by supplying voltages to respective electrodes arranged with the or each quantum bit unit.

8. The method according to any preceding claim, wherein step (ii) comprises modulating coupling between the data qubit and reference qubit within all quantum bit units such that the data qubit and reference qubit within each quantum bit unit have respective different couplings.

9. The method according to any preceding claim, further comprising a step of:
(iii) modulating coupling between data qubits of different quantum bit units to shift energy levels within the set of non-degenerate energy levels to provide separately addressable transitions within the set of non-degenerate energy levels for use in the quantum logic gate.

10. The method according to claim 9, wherein data qubits of different quantum bit units are coupled via a multi-electron coupler, the multi-electron coupler comprising a quantum dot in which an even number of electrons are confined, the quantum dot of the multi-electron coupler being separated from each of the data qubits by respective potential barriers.

11. The method according to claim 9 or claim 10, further comprising a step of:
(iv) driving one or more single-qubit rotations to transition at least one data qubit between energy levels to implement the quantum logic gate.

12. The method according to claim 11, wherein step (iv) comprises transitioning a target qubit among the data qubits between energy levels, the transition being conditional on the states of control qubits, the control qubits comprising data qubits other than the target qubit.

13. The method according to claim 12, wherein each of the data qubits has an upper computational basis energy level and a lower computational basis energy level,
wherein step (iv) comprises transitioning the target qubit between its upper and lower computational basis energy levels only if the control qubits are all in their respective upper computational basis energy levels, thereby implementing a Toffoli gate as the quantum logic gate.

14. A computer-readable medium comprising instructions which, when executed by a computer, cause the computer to carry out the method according to any one of claims 1 to 13.

15. A quantum device comprising:
a set of quantum bit units, each quantum bit unit comprising a data qubit and a reference qubit; and
a controller configured to perform the method according to any one of claims 1 to 13.
